# EUROPEAN PATENT APPLICATION

(11) **EP 1 093 143 A1**
(43) Date of publication of application: **18.04.2001**
(21) Application number: 00308858.0
(22) Date of filing: 09.10.2000
(51) Int. Cl.: H01H 59/00, H01L 25/065, H01H 50/00

(54) **Flip-chip bonded micro-relay on integrated circuit chip**

(30) Priority: 15.10.1999 US 418857
(71) Applicant: LUCENT TECHNOLOGIES INC., Murray Hill, New Jersey 07974-0636 (US)
(72) Inventor: Bishop, David John, Summit, New Jersey 07901 (US); Bolle, Christain A., North Plainfield, New Jersey 07060 (US); Kim, Jungsang, Basking Ridge, New Jersey 07920 (US); Pardo, Flavio, New Providence, New Jersey 07974 (US)
(74) Representative: Buckley, Christopher Simon Thirsk

(57) **Abstract**

Hybrid integrated circuits comprise a micro-electro mechanical systems (MEMS) relay which is flip-chip bonded to a CMOS chip. By bonding the CMOS chip to the MEMS micro-relay, a robust electrical connection is made between the relayed chip for high integrity electrical transmission through the hybrid circuit. Moreover, the electrical signal propagation delays between the CMOS and MEMS chips are greatly reduced to thereby allow the hybrid integrated circuits to be used in high bandwidth applications.

## Description

### Field of the Invention

The present invention relates to hybrid integrated circuits having micro-electromechanical systems (MEMS) chips bonded to CMOS chips. More specifically, the present invention relates to MEMS relays integrated on CMOS circuitry.

### 2 Description of the Related Art

Mechanical relays play an important role in various electronic systems. Examples of such systems include communication switch equipment for individual phone connections and electronic test equipment wherein functions like "range selection" may be implemented using mechanical relays. Solid state switches that replace mechanical relays and provide electrical connection and isolation using semiconductor materials are widely used in many applications. However, such solid state switches possess relatively low off-state resistance and have limited bandwidth. For applications where such properties are necessary, mechanical relays are therefore still widely used.

Although most of the electronic functions of an integrated circuit are typically placed onto a single silicon CMOS chip, the mechanical relay function is still generally carried out using separately-packaged relays off the chip when such functions are necessary. Such an arrangement results in several problems. First, the mechanical relay is the single component that occupies the most space in the total system core hardware. Second, as the integration scale of CMOS circuitry increases, the number of mechanical relays that need to be connected to such a CMOS chip increases. Since the physical space around the CMOS chip is limited, larger-scale integration of additional physical components becomes more difficult, eventually reaching a point of diminishing returns wherein it is simply not possible to add additional parts, such as additional mechanical relays, to the circuit.

Third, the connection between the CMOS chip and the mechanical relays must be designed to accommodate the required bandwidth. For large bandwidth applications, even when the connection is carefully designed the physical distance between the relay and the chip introduces a time delay in communication between them. Additionally, conventional mechanical relays that are widely used today are bulky and expensive, so that utilizing them in densely packed integrated circuit designs is prohibitive.

Accordingly, there is a long-felt need in the art for relays that can be used with integrated circuits and that are cost-effective and easily integrable. Such relays should be integrable with the circuitry architecture of the chip and be adaptable for wide bandwidth applications.

### Summary Of The Invention

The present invention provides an article comprising a MEMS chip which includes a micromachined mechanical relay fabricated in a MEMS fabrication process. This MEMS chip is bonded to an integrated circuit where relay action is required, that is, there are connections on this IC chip that need to be established when necessary. Actuation of MEMS relays on the MEMS chip will establish connections in the integrated circuit chips via mechanical action. In a preferred embodiment, the MEMS chip is flip-chip bonded to the integrated circuit chip, although other bonding techniques may be employed.

The inventive hybrid circuits provide the functionality of a relay on and integrated with an integrated circuit. While it is preferred that the integrated circuit chip be a CMOS integrated circuit chip, any type of integrated circuit chip that can be bonded to a MEMS chip having a micromachined relay in accordance with the invention may utilize the inventive techniques disclosed and claimed herein. As the integration level of the integrated circuits increases, the number of relays that need to be integrated also increases. The conventional methods, where in separate mechanical relays are individually bonded to an integrated circuit, have severe limitations in this respect, since the edge to which relays can be bonded to is limited. Going to a larger number of relays in conventional technology requires a fan-out structure of the electrical interconnects, and thus a time delay in the communication between the integrated circuits and the relays. Such integration bottleneck is absent in the bonded hybrid chip disclosed in the present invention. Moreover, by using a careful embodiment of the inventive MEMS relays, valuable integrated circuit real estate can be conserved, thereby increasing the efficiency of fabricating hybrid integrated circuits. Additionally, by bonding the integrated circuits to the MEMS chips electrical communication delays between the relays on the MEMS chip and the circuitry on the integrated circuit chip are greatly reduced which allows the hybrid circuits of the present invention to be used in high bandwidth applications.

These and other features of the present invention will become apparent from the following detailed description considered in conjunction with the accompanying drawings. It is to be understood, however, that the drawings are designed solely for purposes of illustration and not as a definition of the limits of the invention, for which reference should be made to the appended claims.

Other objects and features of the present invention will become apparent from the following detailed description considered in conjunction with the accompanying drawings. It is to be understood, however, that the drawings are designed solely for purposes of illustration and not as a definition of the limits of the invention, for which reference should be made to the appended claims. It should be further understood that the drawings are not necessarily drawn to scale and that, unless otherwise indicated, they are merely intended to conceptually illustrate the structures and procedures described herein.

### Brief Description Of The Drawings

In the drawings, wherein like reference numerals refer to like elements throughout the several views thereof:
Figure 1 is a schematic, elevated perspective view of a micromachined relay fabricated on an independent MEMS chip, and an associated CMOS chip that carries its counterpart electrical element which is operable to make an electrical connection with the relay on the MEMS chip when the two chips are bonded together;
Figure 2 is schematic, elevated perspective view of the MEMS micro-relay of Figure 1 integrated with the associated CMOS chip using flip-chip bonding techniques;
Figure 3 is cross-sectional view of the hybrid circuit of Figures 1 and 2 after assembly;
Figure 4 is a schematic, elevated perspective view of a hybrid integrated circuit of the present invention wherein a separate section of a CMOS chip is used to integrate the MEMS relay;
Figure 5 is schematic, elevated perspective view of a hybrid integrated circuit of the present invention wherein a carrier wafer having fabricated interconnect wiring is used to integrate the MEMS relay with a CMOS chip; and
Figure 6 is a schematic, elevated perspective view of a hybrid integrated circuit of the present invention wherein an uppermost layer of a CMOS chip is comprises the elements for electrical communication with the MEMS relay, which is integratable on top of the CMOS layer.

### Detailed Description Of The Presently Preferred Embodiments

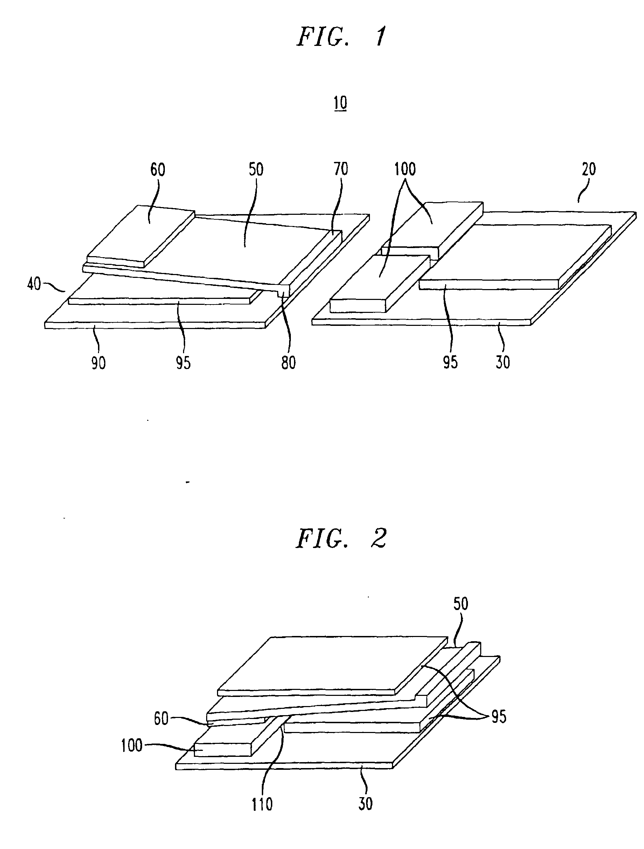

Referring now to the drawings, a hybrid relay circuit of the present invention is shown at 10 in Figures 1, 2 and 3. Circuit 10 may for example comprise a conventional integrated circuit chip 20 that contains the circuit elements to perform the particular functions for which the hybrid circuit 10 is designed. In a preferred embodiment, integrated circuit 20 is a CMOS circuit, but those skilled in the art will appreciate that any type of integrated circuit may be used in hybrid circuit 10. CMOS integrated circuit chip 20 further comprises a substrate 30 which conventionally comprises silicon, but may also comprise other semiconductor materials such as Ge, GaAs, InP and others depending on the particular application intended for the hybrid circuits of the present invention.

In the embodiment of Figures 1, 2 and 3, the MEMS chip 40 comprises a micro-relay that is agreeable as an electrostatically actuated switch. The micro-relay includes a mobile micromachine 50 that carries an electrical contact pad or bridge electrode 60 movable with the micromachine 50 into electrical contact with an element on CMOS chip 20 to complete the electrical connection between the two chips. Even more preferably, the mobile micromachine 50 comprises a cantilever arm 70 having an end 80 anchored to a substrate 90 of MEMS chip 40. Substrate 90 also conventionally comprises silicon, but ultimately similarly comprise other semiconductor materials depending on the particular applications in which the MEMS devices fabricated thereon will be used. In a preferred form, the bridge electrode 60 has a thickness of from about 0.01 microns to about 10 microns on its top. Still more preferably, the cantilever arm 70 has a width from about 1 micron to about 10,000 microns on each side and a thickness from about 0.01 microns to about 10 microns. For ideal relay operation, where a control circuit for the MEMS device on chip 40 and the main circuitry on chip 20 are electrically isolated, the cantilever arm 70 may comprise an insulator-like silicon dioxide or silicon nitride composition.

Alternately, the cantilever arm 70 may comprise a conductor and the electrical bridge contact or pad 60 may be deposited above an insulating layer (not shown in the Figures) on cantilever arm 70. In such an embodiment, the thickness of the insulating layer will be between about 0.01 microns and about 100 microns.

The CMOS chip 20 further comprises the requisite contact electrodes 100 that will allow the cantilever arm 70 and electrode 60 to complete the electrical connection necessary for the circuit function. Both the MEMS chip 40 and the CMOS chip 30 also comprise actuation electrodes 95 fabricated on their respective substrates 90, 30 and to operatively pull the mobile micromachine cantilever arm 70 and bridge electrode 60 towards the contact electrodes 100 with an electrostatic force created by selectively applying a voltage to the electrodes 95. In this manner, electrical contact can be made between contact electrodes 100 and the bridge electrode 60 so that a robust electrical connection can be effectuated between the contact electrodes 100 to ensure that stable transmission of electrical signals can take place through the contact electrodes 100.

The CMOS chip 20 is fabricated using conventional CMOS fabrication technology, while the MEMS chip 40 is fabricated using a MEMS fabrication process. Alternately, commercial MEMS micro-relays may be used such as those available from Cronos Integrated Microsystems, Inc., of Research Triangle Park, North Carolina.

As will be appreciated, it is necessary to bond the two chips together; however, the MEMS fabrication and CMOS fabrication processes are not generally compatible, so that an independent bonding technique must be applied to achieve chip bonding. The independent bonding technique will result in a bonded hybrid circuit wherein the MEMS chip 40 is bonded to the CMOS chip 20 as shown in Figure 2.

While any suitable bonding technique may be used to bond together the two chips 20, 40, in a preferred embodiment the two chips are bonded using a heat activation technique wherein a heat sensitive adhesive is applied between the two parts to be bonded together, following which heat and pressure applied to the two pieces so that the adhesive can anneal. Upon cooling, a hard, solid seal between the two substrates treated with the adhesive has been created.

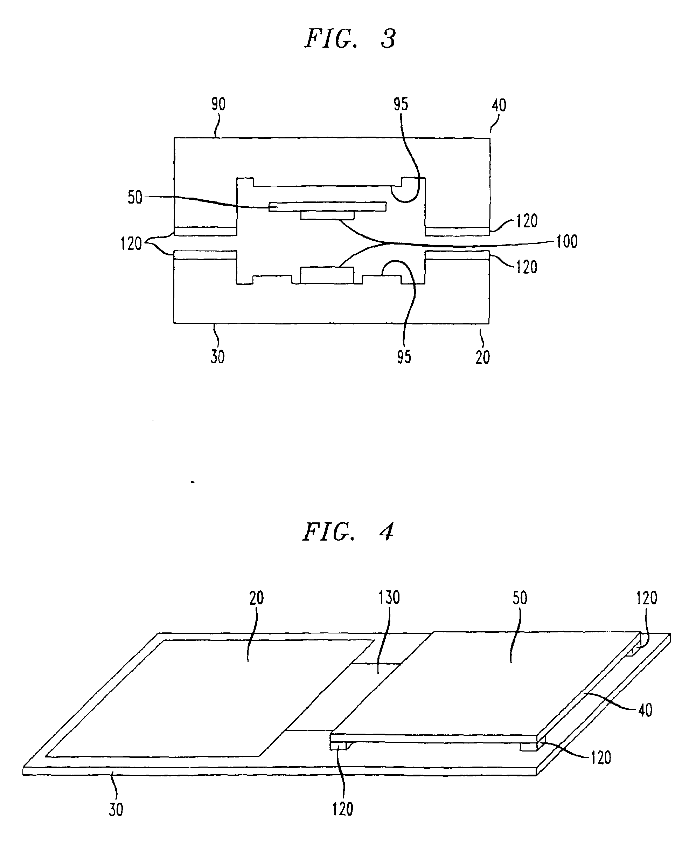

When the two substrates 30, 90 are flip-chip bonded together, a spacing or gap 110 between the chips 20, 40 will be formed. That gap and more particularly the spacing between each of the actuation electrodes 95 and the movable portion of the micromachine 50 -- is determinative of the correct or appropriate operating voltage for actuating the MEMS relay 50. In a preferred embodiment, the width of gap 110 is between about 0.1 microns and about 100 microns. The gap 110 can be controlled precisely during the flip-chip bonding process by utilizing spacers 120 (shown in Figure 3) of known thickness. Such spacers can be fabricated on either of the substrates 30, 90 using either the MEMS or the CMOS fabrication process, or both. When a voltage is applied between the actuation electrodes 95 and the mobile micromachine 50, the cantilever arm 70 is and moved or attracted towards the CMOS chip 20. In this manner, the bridge electrode 60 the mobile micromachine 50 establishes the electrical connection to the contact electrodes 100 on the CMOS chip 20.

It will be appreciated by those skilled in the art that other types of actuation mechanisms other than the cantilever arm 70 shown in Figures 1, 2 and 3 can be fabricated to implement a MEMS relay so long as the electrical connection to the CMOS chip can similarly be established by the flip-chip bonding process. Such electrical connections can be achieved with other MEMS relay devices by utilizing the spacers 120.

Independent of how the particular MEMS relay functions, integration of the relay function onto the CMOS chip is a fundamental aspect of the present invention. Figure 4 depicts a preferred embodiment of a hybrid circuit of the invention wherein illustrating the integration. In the embodiment of Figure 4, the electrical interconnection between the CMOS chip 20 and MEMS chip 40 may be laid out during the CMOS fabrication process, in which, a separate CMOS-MEMS interconnection pad 130 is joined from the CMOS chip 20 to the MEMS chip 40, to establish an electrical connection therebetween. MEMS relays 50 are preferably integrated onto part of the CMOS chip 20 by flip-chip bonding, as described above. The contact electrodes 100 and the actuation electrode 95 necessary for completing the relay function are fabricated on CMOS chip at the area underneath where the MEMS chip is flip-chip bonded. This embodiment is relatively simple to implement, but suffers from the fact that the CMOS-MEMS interconnection 130, the contact electrodes 100, and actuation electrodes 95 take up a large space and CMOS real estate can be quite expensive. In this embodiment, a significant portion of the silicon chip that goes through CMOS processing actually does not carry CMOS circuitry but is rather dedicated to the interconnection 130 and mating electrodes 100, 95 for the MEMS relays, thus incurring unnecessary costs in fabrication of the CMOS chip.

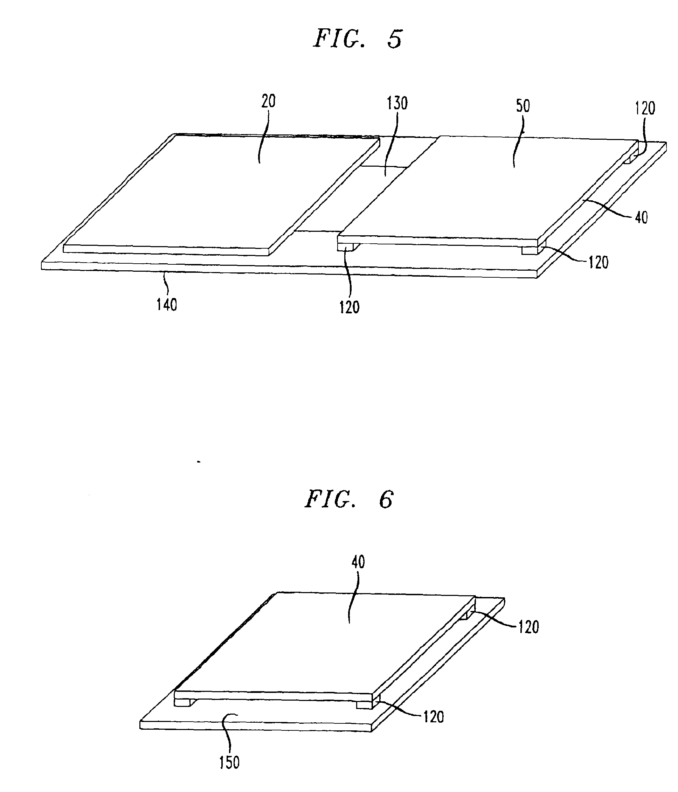

A second approach to integrating the relay function is shown in Figure 5. In this embodiment, a third carrier wafer 140 is fabricated, that carries the CMOS-MEMS electrical interconnect 130, the electrical connection pads 100, actuation electrodes 95, and the mating electrodes for CMOS chip. The CMOS chip 20 and MEMS chip 40 are then independently flip-chip bonded onto carrier wafer 140. Since wafer 140 does not itself proceed through the full CMOS fabrication process, the cost to produce the hybrid circuit of Figure 5 is very low.

Yet a third approach to the MEMS relay integration issue of the invention is shown in Figure 6. In this embodiment, processing steps are added in the CMOS process to fabricate the MEMS relay electrical connections 100 and the actuation electrode 95 in the uppermost layers 150 of CMOS chip 20. The MEMS relay chip 40 is then directly flip-chip bonded onto CMOS chip 20, as discussed above. Because this embodiment requires a modification of the CMOS process itself, it should be considered only if the relay functionality is absolutely critical in the total performance of the CMOS chip.

Regardless of which of the embodiments discussed above is utilized in accordance with the present invention, the inventive hybrid integrated circuits effectively integrate a MEMS relay with an integrated circuit chip cost-effectively and robustly. The inventive circuits utilize only a small amount of CMOS real estate and are particularly useful in high bandwidth applications. Such results have not heretofore been achieved in the art.

While there have been shown and described certain novel features of the invention as applied to preferred embodiments thereof, it will be that various omissions and substitutions and changes in the methods and apparatus described herein, and in their operation, may be made by those skilled in the art without departing from the spirit and scope of the invention. It is expressly intended that all combinations of those elements and/or method steps which perform substantially the same function in substantially the same way to achieve the same result are within the scope of the invention. Substitutions of elements from one described embodiment to another are also fully intended and contemplated. It is the intention, therefore, to be limited only as indicated by the scope of the claims appended hereto.

Thus, while there have shown and described and pointed out fundamental novel features of the invention as applied to a preferred embodiment thereof, it will be understood that various omissions and substitutions and changes in the form and details of the devices illustrated, and in their operation, may be made by those skilled in the art without departing from the spirit of the invention. For example, it is expressly intended that all combinations of those elements and/or method steps which perform substantially the same function in substantially the same way to achieve the same results are within the scope of the invention. Moreover, it should be recognized that structures and/or elements and/or method steps shown and/or described in connection with any disclosed form or embodiment of the invention may be incorporated in any other disclosed or described or suggested form or embodiment as a general matter of design choice. It is the intention, therefore, to be limited only as indicated by the scope of the claims appended hereto.

## Claims

1. A hybrid integrated circuit, comprising:
a micro-electromechanical systems (MEMS) chip comprising a MEMS relay having a portion operatively moveable between a first position and a second position to complete an electrical connection to said MEMS relay in one of said first and second positions of the MEMS relay; and
an integrated circuit chip bonded to said MEMS chip to form a unitary structure defining said hybrid integrated circuit, said integrated circuit chip comprising an element located on said integrated circuit chip for electrical contact with said MEMS relay in said one of said first and second positions and so as to be out of electrical contact with said MEMS relay in the other of said first and second positions to thereby complete an electrical connection between said MEMS chip and said integrated circuit chip in said one of said first and second positions when said integrated circuit chip is bonded to said MEMS chip.

2. The hybrid circuit of claim 1, wherein said MEMS chip further comprises a substrate and said relay comprises a micromachined cantilever arm formed on the substrate and actuable by an electrostatic force to displace said arm between said first and second positions for contact of said arm with said element of the integrated circuit chip to establish electrical contact between said arm and element and thereby complete said electrical connection between the integrated circuit chip and the MEMS chip in said one of the first and second positions.

3. The hybrid circuit of claim 2, wherein said cantilever arm comprises a bridge electrode carried on an end of the cantilever arm for electrical contact with said element on the integrated circuit chip.

4. The hybrid circuit of claim 3, wherein said element on the integrated circuit chip comprises a contact electrode.

5. The hybrid circuit of claim 4, further comprising an actuation electrode on the MEMS device substrate for generating the electrostatic force on the cantilever arm to cause said displacement of the cantilever arm between said first and second positions.

6. The hybrid circuit of claim 5, wherein said bond between the integrated circuit chip and the MEMS chip comprises a flip-chip bond.

7. The hybrid circuit of claim 6, wherein said integrated circuit chip comprises a CMOS chip.

8. The hybrid circuit of claim 7, further comprising a plurality of spacers fabricated on the substrate of said MEMS chip for controlling a width of a gap defined between the CMOS integrated circuit chip and the MEMS chip bonded together by said flip-chip bond.

9. The hybrid circuit of claim 1, further comprising an interconnection pad independently joining the integrated circuit chip to the MEMS chip for providing permanent electrical interconnection between the integrated circuit chip and the MEMS chip.

10. The hybrid circuit of claim 1, wherein said MEMS chip is fabricated on a layer of said integrated circuit chip.
